(19) Europäisches Patentamt
European Patent Office
Office européen des brevets

(11) **EP 3 586 484 B1**

(12) **EUROPEAN PATENT SPECIFICATION**

(45) Date of publication and mention
of the grant of the patent:
**07.04.2021 Bulletin 2021/14**

(21) Application number: **17897972.0**

(22) Date of filing: **27.02.2017**

(51) Int Cl.:
*H04L 27/26* (2006.01)        *G11C 7/02* (2006.01)
*G11C 7/10* (2006.01)         *G11C 8/04* (2006.01)
*G11C 11/4076* (2006.01)      *G11C 11/408* (2006.01)
*H03M 13/25* (2006.01)        *H03M 13/27* (2006.01)
*H03M 13/00* (2006.01)        *H04L 1/00* (2006.01)
*G11C 11/4096* (2006.01)

(86) International application number:
**PCT/CN2017/075030**

(87) International publication number:
**WO 2018/152841 (30.08.2018 Gazette 2018/35)**

(54) **APPARATUS FOR PERFORMING DEINTERLEAVING OF A BINARY DATA STREAM AND DVB-T2 RECEIVER**

VORRICHTUNG ZUR DURCHFÜHRUNG DER ENTSCHACHTELUNG EINES BINÄREN DATENSTROMS UND DVB-T2-EMPFÄNGER

APPAREIL POUR DÉSENTRELACER UN FLUX DE DONNÉES BINAIRES ET RÉCEPTEUR DVB-T2

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.01.2020 Bulletin 2020/01**

(73) Proprietor: **Alto Beam (China) Inc.**
**Beijing 100083 (CN)**

(72) Inventors:
- **MEI, Guoqiang**
  **Beijing 100083 (CN)**
- **LIN, Zhihao**
  **Beijing 100083 (CN)**
- **ZENG, Chaohuang**
  **Beijing 100083 (CN)**
- **WANG, Xiaohui**
  **Beijing 100083 (CN)**
- **WANG, Junwei**
  **Beijing 100083 (CN)**

(74) Representative: **Zacco Denmark A/S**
**Arne Jacobsens Allé 15**
**2300 Copenhagen S (DK)**

(56) References cited:
EP-A1- 1 998 461          EP-A2- 2 525 538
EP-A2- 2 525 538          KR-B1- 100 662 804
US-A1- 2014 068 168

**Description**

**Field**

The present invention pertains to apparatus for performing deinterleaving of a binary data stream.

**Background**

Many telecommunication standards require that the transmitted data streams are interleaved at the sender and deinterleaved at the receiver, to improve the resistance of the forward error correction (FEC) mechanisms against burst noise. This is also the case for DVB-T2 senders/receivers. In view of the large number of memory accesses required to implement the deinterleaving process, known deinterleaving apparatus operate on on-chip SRAM memory. There is a need for a deinterleaving apparatus that can offer the same performance as the SRAM-based implementations, without relying on costly SRAM memory. Publication US 2014/068168 A1 discloses tile base interleaving and de-interleaving of row-column interleaved data. Publication EP2525538 A2 discloses a decoding circuit including deinterleavers adapted to perform time-domain deinterleaving of input data to reconstruct original data in the original order written in a DRAM.

**Summary**

According to an aspect of the present invention, there is provided an apparatus for performing deinterleaving of a binary data stream, the apparatus comprising a mapping device and a semiconductor memory; said mapping device comprising: an input interface arranged to receive said binary data stream and an output interface arranged to output a deinterleaved instance of said binary data stream; a row mapper, operatively connected to said input interface and said semiconductor memory, said row mapper being configured to group data received through said binary data stream into "write" commands for said semiconductor memory; and a row deinterleaver, operatively connected to said semiconductor memory and said output interface, said row deinterleaver being configured to present deinterleaved data, retrieved from said semiconductor memory by means of "read" commands, to said output interface; wherein said semiconductor memory is an SDRAM memory; and wherein each of said "write" commands is an SDRAM write command for at least part of an SDRAM row, said SDRAM write commands being calculated such that said deinterleaved data can be written to and read out in SDRAM burst mode.

To date, SDRAM memories have not been used for deinterleavers, because of their bandwidth limitations; the bandwidth of SDRAM is only about 1/8 of that of SRAM because its lower speed, read/write access overhead, read/write I/O sharing, etc. It is an advantage of the invention that it allows the use of SDRAM as the memory of the deinterleaver, instead of the costlier on-chip SRAM that is traditionally used. The inventors have found that where a traditional ping-pong method of deinterleaving would need 19.126 Mbits of memory, an implementation in accordance with the present invention could be achieved with only 9.625 Mbits, thus allowing the use of 16 Mbits SDRAM, which will reduce the cost of the deinterleaver memory by 80%.

The present invention is based *inter alia* on the insight of the inventors that by providing a row mapper that acts on the received data stream prior to its storage in the external memory, a data ordering can be achieved that permits the retrieval of deinterleaved data at a reduced bandwidth, in particular by using a burst-read operation on an SDRAM memory.

In an embodiment of the apparatus according to the present invention, the output interface is operatively connected to a FEC mapper.

As deinterleavers are often used in conjunction with a forward error correction (FEC) mechanism (e.g., a Reed-Solomon coder), it is particularly advantageous to design the apparatus in such a way that it interfaces directly with a forward error correction (FEC) mapper.

In a particular embodiment, the SDRAM "read" commands are buffered using the FEC mapper for burst reading.

It has been observed that, while cell reading from the forward error correction (FEC) block should be sequential, the corresponding SDRAM rows of these sequential cells could be very random. The present embodiment is based on the insight of the inventors that the FEC mapper's buffer can be used to group and buffer the cell read commands of the same SDRAM row so we can perform SDRAM read access with burst commands to reduce the bandwidth requirements. Thus, preferably, the cell read commands of the same SDRAM rows are grouped and buffered in the FEC mapper.

In an embodiment of the apparatus according to the present invention, the mapping device comprises two (preferably small) SRAM memories, the mapping device being configured to iteratively generate a write address for one of the "write" commands and a read address for one of the "read" commands in respective ones of the SRAM memories.

It is an advantage of this embodiment that it provides a particularly efficient use of the required SRAM memory, thus further reducing the cost and size of the overall apparatus. In particular, the total required memory capacity is reduced, because the memory space can be quickly recycled.

In an embodiment of the apparatus according to the present invention, the deinterleaving is performed on the basis of an SDRAM row instead of a TDI cell basis.

This embodiment is based on the insight of the inventors that although the number of cells of time-deinterleaving is quite large, they could be grouped into one row or multiple rows of SDRAM for deinterleaving, and the deinterleaving is performed on an SDRAM row basis instead of a cell basis, thus making the use of SDRAM possible.

In an embodiment of the apparatus according to the present invention, the row mapper performs mapping from TDI cells to SDRAM rows and buffers SDRAM write access command for SDRAM burst writing.

The row mapper essentially performs as a mapper for time-deinterleaving cells to SDRAM rows. The burst-write step does not necessarily cover a full SDRAM row, but could cover a part of an SDRAM row. By judicious dimensioning of the row mapper, based on the number of FEC blocks in a TI block, $N_{fec}$, the SDRAM burst write process can be performed continuously.

According to an aspect of the present invention, a DVB-T2 receiver is provided comprising the apparatus as described above.

A Digital Video Broadcasting - Second Generation Terrestrial, DVB-T2, receiver is required by the relevant standards to include a deinterleaver. The inventors have found that the deinterleaving apparatus of the present invention is particularly well suited to implement the deinterleaver required by the DVB-T2 standards.

The invention is set out in the appended independent claim. Advantageous embodiments are defined by the appended dependent claims.

## Brief Description of the Drawings

These and other features and advantages of embodiments of the present invention will now be described in more detail with reference to the accompanying figures, in which

- Fig. 1 illustrates an interleaver structure;
- Fig. 2 illustrates the interaction of a deinterleaver and an interleaver;
- Fig. 3 illustrates an exemplary "ping-pong" structure of a deinterleaver
- Fig. 4 illustrates a one-block memory structure for a deinterleaver;
- Fig. 5 presents a top-level architecture of a time deinterleaver;
- Fig. 6 illustrates a row mapper of a deinterleaver according to an embodiment of the present invention;
- Fig. 7 illustrates a relation of a deinterleaving sequence with a FEC block;
- Fig. 8 illustrates a conceptual mapping between FEC blocks and SDRAM row storage according to an embodiment of the present invention;
- Fig. 9 schematically illustrates a row deinterleaver with two buffers according to an embodiment of the present invention;
- Fig. 10 presents a typical unit map sequence according to an embodiment of the present invention; and
- Fig. 11 illustrates a FEC mapper structure according to an embodiment of the present invention.

## Detailed Description of the Embodiments

Definitions

- **16-QAM:** 16-ary QUADRATURE Amplitude Modulation
- **256-QAM:** 256-ary QUADRATURE Amplitude Modulation
- **64-QAM:** 64-ary QUADRATURE Amplitude Modulation
- **QPSK:** Quaternary Phase Shift Keying
- **DVB T2:** Digital Video Broadcasting - Second Generation Terrestrial
- **OFDM:** orthogonal frequency-division multiplexing
- **LDPC:** low-density parity check code
- **FEC:** forward error correction
- **TI:** time interleaving
- **TDI:** time deinterleaving
- **FEC Block:** set of $N_{cells}$ OFDM cells carrying all the bits of one LDPC FECFRAME
- **FECFRAME:** set of $N_{ldpc}$ (16200 or 64800) bits from one LDPC encoding operation
- **OFDM cell:** modulation value for one OFDM carrier during one OFDM symbol, e.g., a single constellation point
- **TI-block:** set of cells within which time interleaving is carried out, corresponding to one use of the time INTERLEAVER memory
- **PLP:** Physical Layer Pipe
- **Data PLP:** PLP of Type 1 or Type 2
- **Common PLP:** PLP having one slice per T2-FRAME, Transmitted after the L1 signalling and any bias balancing cells, which may contain data shared by multiple PLPS.
- **SDRAM:** Synchronous Dynamic Random Access Memory, including both SDR (single data rate) and DDR (double data rate) SDRAM.
- **SRAM:** Static random-access memory
- **DDR:** Double data rate

Symbols and Abbreviations

- $N_{ldpc}$: Number of bits of a FEC FRAME, should be 16400 or 64800
- $N_{cells}$: Number of cells of a FEC Block (Table 1)
- $N_{fec}$: Number of FEC Blocks in a TI Block
- $N_r$: Number of rows in time INTERLEAVER
- $N_c$: Number of columns in time INTERLEAVER
- **TDI_W** : bit width of DEINTERLEAVER cell data (18 in the disclosed embodiment)
- $row_{ceil}$: Ceiling of SDRAM ROW number for a FEC-BLOCK

The present invention pertains to a novel way to implement DVB-T2 time deinterleaving using SDRAM, for example 16Mbits SDRAM. An preferred embodiment requires about 13Mbits SDRAM and less than 300kbits SRAM. In this scheme, the bandwidth requirement of SDRAM is small because SDRAM burst read and burst write are used. The SDRAM clock can be set at a relatively low speed of 70MHz. Moreover, because of the small bandwidth and extra memory left in the SDRAM, an extra DEJITTER buffer as specified in the DVB-T2 standard could be included in the same scheme.

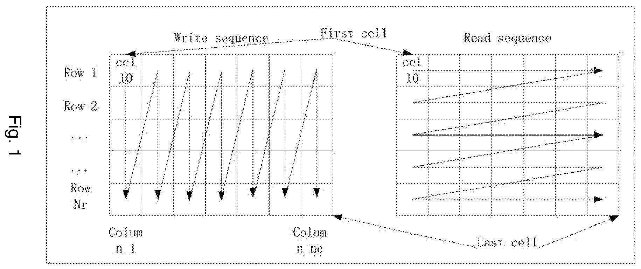

In a typical wireless communication system, a time INTERLEAVER (TI) is provided on the transmitter side and a DEINTERLEAVER (TDI) is provided on the receiver side to deal with burst noise interference. A structure of a time INTERLEAVER in a DVB-T2 system is shown in Figure 1.

The basic unit of time deinterleaving (TDI) is a **TDI-block,** which is a rectangle, with a length of $N_r$ and a width of $N_c$. The total cell numbers of a TDI block should be $N_r*N_c$. The process of time interleaving is to write the input cells column by column, then read the output cells row by row.

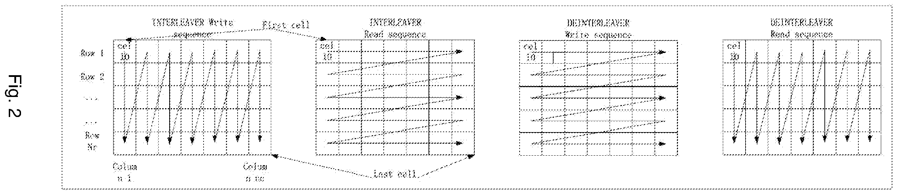

It can be seen that the simplest way to implement the time deinterleaving (TDI) process, is to write the rectangular **TDI-block** just as it is read in the INTERLEAVER and then read it as it is written in the INTERLEAVER. This leads to the cascade diagram illustrated in Figure 2.

The schemes of Figure 1 and Figure 2 for time interleaving write sequence, $TI_{wsequence}$, and time interleaving read sequence, $TI_{rsequence}$, can be summarized in formulas (1) and (2) respectively:

$$TI_{wsequence} = row + column * N_r \qquad (1)$$

$$TI_{rsequence} = row * N_c + column \qquad (2)$$

The *row* and *column* can be derived from the following formulas:

$$row = \text{mod}(TI_{wsequence}, N_r) \qquad (3)$$

$$column = \text{floor}(\frac{TI_{wsequence}}{Nr}) \qquad (4)$$

The time deinterleaving (TDI) process is simply the opposite of the time interleaving (TI) process, and follows the following formulas:

$$\text{TDI}_{\text{wsequence}} = \text{TI}_{\text{rsequence}} = row * \text{N}_c + column \qquad (5)$$

$$\text{TDI}_{\text{rsequence}} = \text{TI}_{\text{wsequence}} = row + column * \text{N}_r \qquad (6)$$

The *row* and *columncan* be derived from following formulas:

$$row = \text{floor}\big(\text{TDI}_{\text{wsequence}}, \text{N}_c\big) = \text{mod}\big(\text{TDI}_{\text{rsequence}}, \text{N}_r\big) \qquad (7)$$

$$column = \text{mod}(\text{TDI}_{\text{wsequence}}, \text{N}_c) = \text{floor}\big(\text{TDI}_{\text{rsequence}}, \text{N}_r\big) \qquad (8)$$

From equations (5),(6),(7), and (8), the following expressions can be derived:

$$\text{TDI}_{\text{rsequence}} = \text{floor}(\text{TDI}_{\text{wsequence}}, \text{N}_c) + \text{mod}(\text{TDI}_{\text{wsequence}}, \text{N}_c) * \text{N}_r \qquad (9)$$

or, conversely:

$$\text{TDI}_{\text{wsequence}} = \text{mod}\big(\text{TDI}_{\text{rsequence}}, \text{N}_r\big) * \text{N}_c + \text{floor}\big(\text{TDI}_{\text{rsequence}}, \text{N}_r\big) \qquad (10)$$

As shown in the following table, the parameters for the DVB-T2 time DEINTERLEAVER are related with two key DVB-T2 parameters, namely LDPC block length ($N_{ldpc}$) and modulation mode (*Mod_type*). When $N_{ldpc}$ and *Mod_type*are determined, the number of cells per LDPC block ($N_{cells}$) and the number of rows ($N_r$) are fully determined.

| LDPC block length ($N_{ldpc}$) | Modulation Mode (*Mod_type*) | Number of cells per LDPC block ($N_{cells}$) | Number of rows ($N_r$) |
|---|---|---|---|
| 64800 | 256-QAM | 8100 | 1620 |
| | 64-QAM | 10800 | 2160 |
| | 16-QAM | 16200 | 3240 |
| | QPSK | 32400 | 6480 |
| 16200 | 256-QAM | 2025 | 405 |
| | 64-QAM | 2700 | 540 |
| | 16-QAM | 4050 | 810 |
| | QPSK | 8100 | 1620 |

Another important parameter from the DVB-T2 specification is the maximum **TI-block** depth, which is defined as $2^{19}+2^{15} = 557056$. The maximum $N_c$ can accordingly be calculated using the following formula:

$$\text{N}_{\text{fec}} * \text{N}_{\text{cells}} = \text{N}_r * \text{N}_c \qquad (11)$$

From the above table, we have $N_{cells} = 5 * N_r$, so that $N_{fec} = N_c/5$. It can be seen that there are 7 modes of $N_r$ in total; the first row and the eigth row have the same mode.

| $N_r$ | Maximum of $N_c$ | Maximum of $N_{fec}$ |
|---|---|---|
| 1620 | 343 | 69 |
| 2160 | 257 | 52 |
| 3240 | 171 | 35 |

(continued)

| $N_r$ | Maximum of $N_c$ | Maximum of $N_{fec}$ |
|---|---|---|
| 6480 | 85 | 17 |
| 405 | 1376 | 276 |
| 540 | 1031 | 207 |
| 810 | 688 | 138 |
| 1620 (same as row 1) | 343 | 69 |

The most straightforward way to implement a DEINTERLEAVER is to use two SRAM memories and use a "ping-pong" operation. One "ping" memory is used to store the incoming TDI block, while another "pong" memory is used to read the existing TDI block. The read and write address sequence of both ping and pong memory is similar.

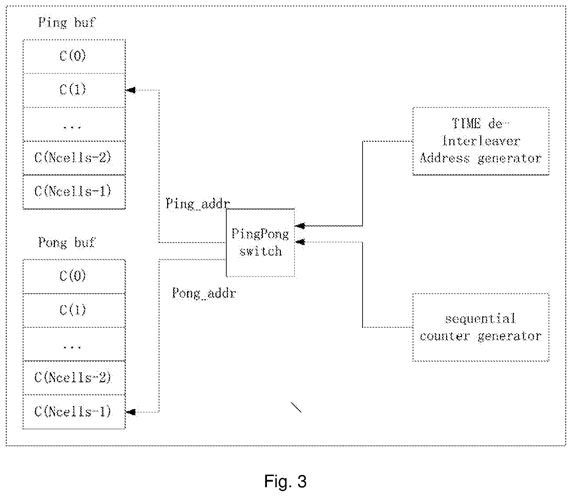

Assuming that the write sequence is in sequential order, the read sequence can be derived by equation (9); if the read sequence is in sequential order, equation (10) can be used. This scheme could also be implemented using two SRAMs, as illustrated in Figure 3.

However, the inventors have found that this scheme is not optimal, as it requires two memories, which will need $(2^{19} + 2^{15})$ * TDI_W*2 bits of memory (about 19.125Mbits).

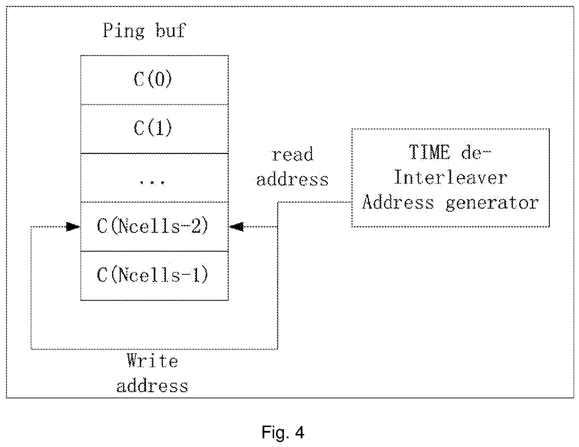

The "Implementation guidelines for a second generation digital terrestrial television broadcasting system (DVB-T2)" (Draft ETSI TR 102 831 3 V0.10.00, 2009-11; hereinafter referred to as the "A133 implementation") describes a more memory-efficient implementation, in which for each **TDI-block,** data cells are read out one at a time from the DEINTERLEAVER memory according to the addressing sequence produced by the address generator. For each cell read out, a new cell from the input is written into the memory at the same address, as this memory location has just been cleared by reading the output cell. This process is illustrated in Figure 4.

The scheme is more efficient in terms of the required memory capacity, and needs only $(2^{19}+2^{15})$*TDI_W, or about 9.5625 Mbits of memory in theory. (In reality, the actual SRAM that would be needed would be larger than 9.5625Mbits due to the margin needed for unused columns.)The inventors have found that this solution is still unsatisfactory, when considering the price of on-chip SRAM compared with external SDRAM. Yet,the SRAM used in this scheme can not simply be replaced with SDRAM directly, because the read and write address are random and would need huge SDRAM bandwidth while SDRAM's bandwidth is much less than that of SRAM.

However, SDRAM has the property of supporting burst read and write in a row, it could access 1,2,4,8 data or a full page in one burst access. When doing burst read or write, the column address could be random.

Hence, one can only read or write a 16-bit TDI cell in one SDRAM operation, which might take as much as 6 cycles due to the SDRAM properties. Considering that the throughput of TDI cells is about 8Mcell/s, the bandwidth requirement would be about 96M cell access per second. Considering also that one TDI cell is 18bits in width while the databus of SDRAM is 16bits, it thus becomes extremely challenging to implement the scheme in SDRAM.

The randomness of the read/write address can be seen from the following formula:

For the first iteration, from formula (9):

$$TDI_{rsequence} = floor(TDI_{wsequence}, N_c) + mod(TDI_{wsequence}, N_c) * N_r$$

For the second iteration, the write sequence of TDI should be the read sequence of the first iteration and will not be sequential.

The read sequence of the TDI would be a permutation of the write sequence and would not be sequential either.

The inventors have found that by modifying the reading and writing scheme, the system can surprisingly be made suitable for implementation in SDRAM.

In an embodiment of the method according to the present invention, it could write 32 18-bits TDI cell to the SDRAM in 4 write accesses of burst of 8 and one write access of burst of 4, which requires only 4*(8+5)+(4+5)=61 cycles (the number 5 is the overhead of SDRAM transmission). This allows an SDRAM implementation while leaving space for sharing the memory with other logic.

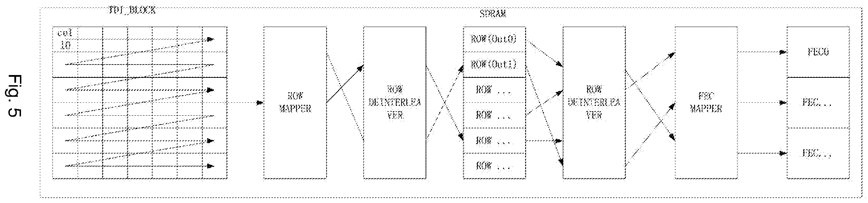

As a whole, the time DEINTERLEAVER device is composed of 3 components: the ROW MAPPER, the ROW DEINTERLEAVER, the FEC MAPPER. The data flow between these blocks is illustrated in Figure 5. When the data to be deinterleaved is received, they are fed to a ROW MAPPPER, which collects relevant data in a ROW together and the data are then written to a row of SDRAM. Next, the ROW DEINTERLEAVER is applied. Finally, the data are read from an SDRAM row in burst read mode and packed to a FEC block.

Contrary to the A133 implementation, the present invention uses the FEC block, or several SDRAM rows, as the basic units of the TIME DEINTERLEAVER (TDI). The read and write operation *between units* should be similar to the way described in the A133 implementation, such that the units released by TDI read operation could be used immediately by TDI write operation. However, *within a TDI unit,* cell sequence is rearranged such that burst read and write access from and to SDRAM are made possible.

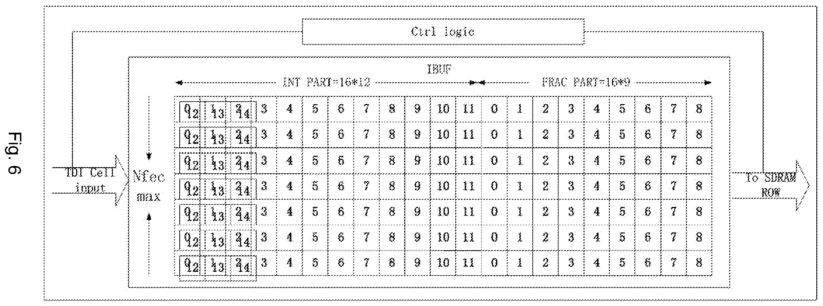

The ROW MAPPER is the device that maps relevant cells in a TDI-BLOCK to a dedicated SDRAM ROW. It has an input buffer and related control logic. A structure of a ROW MAPPER of the DEINTERLEAVER according to an embodiment of the present invention is illustrated in Figure 6.

The input buffer (IBUF) is a 276 x (16*21) bits SRAM (shared by both common and data PLP). The number 276 is maximum FEC block numbers. The number 16 corresponds to the SDRAM bus width. The 21 words are needed to store enough data for SDRAM burst.

Because TDI_W is 18 in the presently disclosed design, which is larger than the SDRAM data bus width of 16, the 21 words are split into 12 integral parts to store the 16bits LSB of TDI_W and 9 fractional parts to store the 2 MSB of TDI_W. The control logic simply sends out integral part or fractional part to SDRAM when it is larger than the burst length.

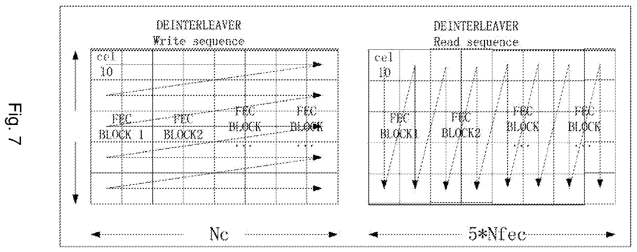

It can be shown that the cells in a TI-block could be buffered by input buffer and transformed to a different SDRAM rows. As shown in Figure2, if TDI cells are written row by row, then they should be read column by column. A column will have $N_r$ rows, which could be divided by $N_{cells}$. Hence, for each FEC Block, the data equals to $\dfrac{N_{cells}}{N_r} = 5$ columns, which is shown in Figure 7.

As indicated above, TI-block cells can be mapped to SDRAM rows. Yet the $N_{cells}$ of a FEC Block are much larger than what an SDRAM row can hold. An SDRAM row could contain 256*16bits, which in turn could contain 224*TDI_W, or 224 TDI cells. From the tables provided above, it can be seen that there are 7 modes of $N_r$ in total.

For each mode, the necessary number of SDRAM rows for a FEC block can be calculated. Multiplying this with the maximum FEC block numbers, results in the maximum necessary numbers of SDRAM rows. The results are shown in the following table:

| LDPC block length ($N_{ldpc}$) | Modulation Mode *(Mod_type)* | Number of cells Per LDPC block ($N_{cells}$) | Ceiling of SDRAM ROW number for a FEC-BLOCK ($row_{ceil}$) | Maximum of $N_{fec}$ | Maximum SDRAM ROW |
|---|---|---|---|---|---|
| 64800 | 256-QAM | 8100 | 37 | 69 | 2553 |
| | 64-QAM | 10800 | 49 | 52 | 2548 |
| | 16-QAM | 16200 | 73 | 35 | 2555 |
| | QPSK | 32400 | 145 | 17 | 2465 |
| 16200 | 256-QAM | 2025 | 10 | 276 | 2760 |
| | 64-QAM | 2700 | 13 | 207 | 2691 |
| | 16-QAM | 4050 | 19 | 138 | 2622 |
| | QPSK | 8100 | 37 | 69 | 2553 |

It is advantageous to add some margin. Accordingly, an exemplary value of ($N_{FEC}$+6) $row_{ceil}$ may be used, so it occupies at most (17+6)*145=3335 SDRAM rows when $N_{cells}$ is 32400. For any modes in which $N_{cells}$ is not equal to 32400, the row that is not used may simply be skipped. In theory, for an input cell, one can determine which FEC it belongs to (*fec_index*) and which row it is in the FEC (*row_index*). The following formula calculates the final SDRAM ROW index for the cell:

$$sd\_row\_index = (fec\_index + (max\_fec\_blocks - cur\_fec\_blocks)) * row\_number + row\_index$$

$$(13)$$

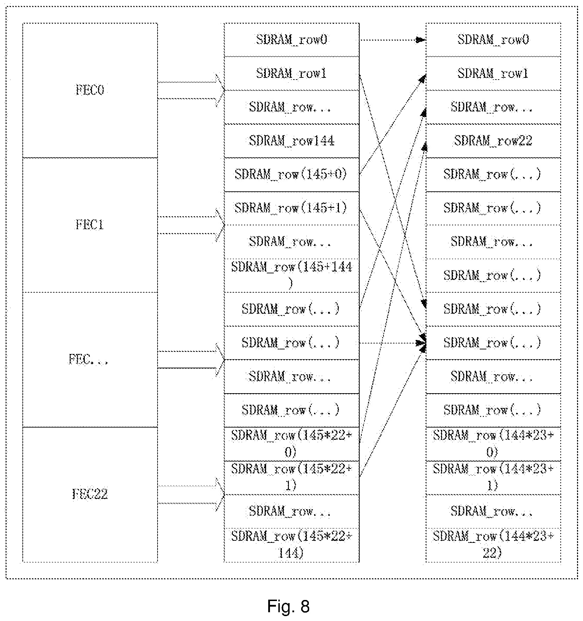

An exemplary conceptual SDRAM storage is illustrated in Figure 8. In fact, *sd_row_index* cannot be fixed with *fec_index* and the *row_index* should change over time for the deinterleaving sequence.

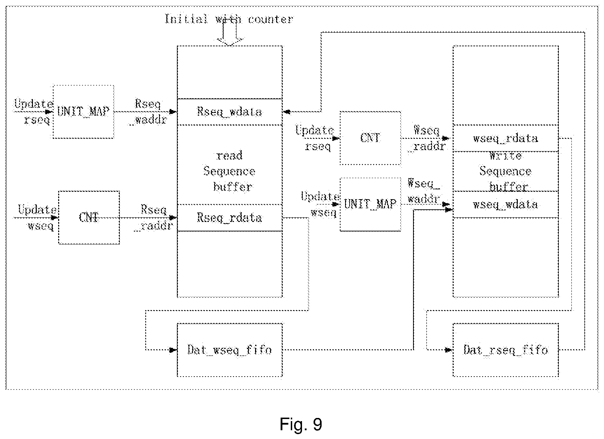

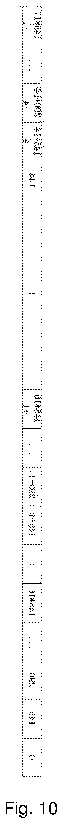

Taking DATA PLP as an example, an exemplary ROW DEINTERLEAVER structure is illustrated in Figure 9. The basic idea of the ROW DEINTERLEAVER is to map the row to the DEINTERLEAVER sequence generated by UNIT_MAP. The UNIT_MAP is a counter with incremental step of a $row_{ceil}$ and will round with ($row_{ceil}$ * Maximum of $N_{FEC}$) -1, when it exceeds the maximum row. Assuming $row_{ceil}$ = 145 and the maximum of $N_{FEC}$ is 17, then the SDRAM's maximum row number is 3335, which will result in the UNIT_MAP sequence shown in Figure 10.

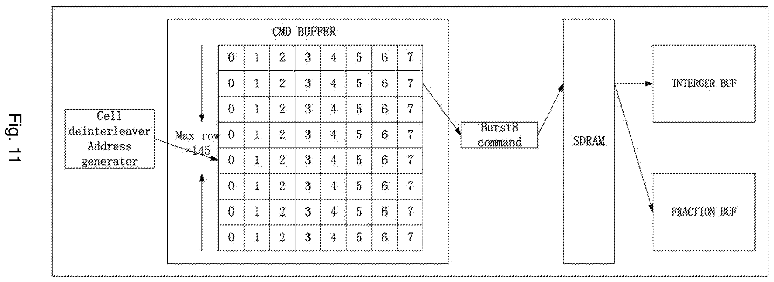

An exemplary FEC MAPPER structure is illustrated in Figure 11. There are 3 buffers in this FEC MAPPER, with an 1160 $\times$ 24 bits command buffer and another two 4050x16 bits data buffers. When FEC block data needs to be outputted, the Cell DEINTERLEAVER address generator is started. It will provide the final read address and its related SDRAM row address of a cell in a FEC block. Then the two addresses are stored into the command buffer, when any row has at least 8 addresses and meets the burst 8 requirement of SDRAM, an SDRAM read will be performed, the 8 data read from SDRAM could be written to INTEGER BUF or FRACTION BUF.

While the invention has been described hereinabove with reference to specific embodiments and specific design parameters, this was done to illustrate and not to limit the invention, the scope of which is to be determined by referring to the accompanying claims.

## Claims

1. An apparatus configured to perform time deinterleaving of a binary data stream in a Digital Video Broadcasting -Second Generation Terrestrial, DVB-T2, receiver, the apparatus comprising a mapping device and a semiconductor memory;

   the mapping device comprising:

   an input interface, arranged to receive the binary data stream in the DVB-T2 receiver;
   an output interface, arranged to output a deinterleaved instance of the binary data stream in the DVB-T2 receiver;
   a row mapper, respectively connected with the input interface and the semiconductor memory, arranged to group data received through the binary data stream in the DVB-T2 receiver into write commands for the semiconductor memory; and
   a row deinterleaver, respectively connected with the semiconductor memory and the output interface, arranged to transmit deinterleaved data, retrieved from the semiconductor memory by means of read commands, to the output interface;
   wherein the semiconductor memory is an Synchronous Dynamic Random Access Memory, SDRAM, memory, each of the write commands is an SDRAM write command for at least part of an SDRAM row, and each SDRAM write command is calculated such that the deinterleaved data is written to and read out in SDRAM burst mode;
   wherein the mapping device comprises two SRAM memories, and the mapping device is arranged to iteratively generate a write address for one of the write commands and a read address for one of the read commands in respective ones of the SRAM memories.

2. The apparatus as claimed in claim 1, wherein the output interface is connected with a Forward Error Correction, FEC, mapper.

3. The apparatus as claimed in claim 2, wherein each SDRAM read command is buffered using the FEC mapper for burst reading.

4. The apparatus as claimed in any one of claims 1-3, wherein the deinterleaving is performed on the basis of an SDRAM row instead of a Time Deinterleaving, TDI, cell basis.

5. The apparatus as claimed in any one of claims 1-3, wherein the row mapper is arranged to perform mapping from TDI cells to SDRAM row and buffer SDRAM write access command for SDRAM burst writing.

6. A Digital Video Broadcasting - Second Generation Terrestrial, DVB-T2, receiver comprising the apparatus as claimed in any one of claims 1-5.

## Patentansprüche

1. Vorrichtung, die zur Durchführung von Zeit-Entschachtelung eines binären Datenstroms in einem Digital Video Broadcasting - Second Generation Terrestrial, DVB-T2-Empfänger ausgelegt ist, wobei die Vorrichtung eine Mappingvorrichtung und einen Halbleiterspeicher umfasst;
   wobei die Mappingvorrichtung Folgendes umfasst:

eine Eingabeschnittstelle, die zum Empfangen des binären Datenstroms in dem DVB-T2-Empfänger ausgelegt ist;

eine Ausgabeschnittstelle, die zur Ausgabe einer entschachtelten Instanz des binären Datenstroms in dem DVB-T2-Empfänger ausgelegt ist;

einen Reihenmapper, der mit jeweils der Eingabeschnittstelle und dem Halbleiterspeicher verbunden und ausgelegt ist, um über den binären Datenstrom in dem DVB-T2-Empfänger empfangene Daten in Schreibbefehle für den Halbleiterspeicher zu gruppieren; und

eine Reihenentschachtelungsvorrichtung, die mit jeweils dem Halbleiterspeicher und der Ausgabeschnittstelle verbunden und ausgelegt ist, um entschachtelte Daten, die durch Lesebefehle von dem Halbleiterspeicher abgerufen sind, an die Ausgabeschnittstelle zu übertragen;

wobei der Halbleiterspeicher ein Synchronous Dynamic Random Access Memory, SDRAM-Speicher ist, jeder der Schreibbefehle ein SDRAM-Schreibbefehl für zumindest einen Teil einer SDRAM-Reihe ist, und jeder SDRAM-Schreibbefehl in einer solchen Weise berechnet ist, dass die entschachtelten Daten im SDRAM-Burst-Modus geschrieben und ausgelesen werden;

wobei die Mappingvorrichtung zwei SRAM-Speicher umfasst, und die Mappingvorrichtung zum iterativen Erzeugen einer Schreibadresse für einen der Schreibbefehle und einer Leseadresse für einen der Lesebefehle in jeweiligen der SRAM-Speicher ausgelegt ist.

2. Vorrichtung nach Anspruch 1, wobei die Ausgabeschnittstelle mit einem Forward Error Correction, FEC-Mapper verbunden ist.

3. Vorrichtung nach Anspruch 2, wobei jeder SDRAM-Lesebefehl unter Verwendung des FEC-Mappers für Burst-Lesen zwischengespeichert ist.

4. Vorrichtung nach einem der Ansprüche 1-3, wobei die Entschachtelung auf der Grundlage einer SDRAM-Reihe anstatt auf der Grundlage einer Time Deinterleaving, TDI-Zelle durchgeführt wird.

5. Vorrichtung nach einem der Ansprüche 1-3, wobei der Reihenmapper ausgelegt ist, um Mapping von TDI-Zellen auf SDRAM-Reihe durchzuführen und SDRAM-Schreibzugriffsbefehle für SDRAM-Burst-Schreiben zwischenzuspeichern.

6. Digital Video Broadcasting - Second Generation Terrestrial, DVB-T2-Empfänger, der die Vorrichtung nach einem der Ansprüche 1-5 umfasst.

**Revendications**

1. Dispositif configuré pour effectuer un désentrelacement temporel d'un flux de données binaires dans un récepteur de diffusion vidéo numérique - deuxième génération terrestre DVB-T2, le dispositif comprenant un dispositif de mappage et une mémoire à semi-conducteurs ;

le dispositif de mappage comprenant :

une interface d'entrée, agencée pour recevoir ledit flux de données binaires dans le récepteur DVB-T2 ;

une interface de sortie, agencée pour sortir une instance désentrelacée dudit flux de données binaires dans le récepteur DVB-T2 ;

un mappeur de rangées, connecté respectivement à la interface d'entrée et à la mémoire à semi-conducteurs, agencé pour regrouper les données reçues par le biais du flux de données binaires dans le récepteur DVB-T2 en commandes d'écriture pour ladite mémoire à semi-conducteurs ; et

un désentrelaceur de rangées, connecté respectivement à la mémoire à semi-conducteurs et à l'interface de sortie, agencé pour transmettre des données désentrelacées, extraites de la mémoire à semi-conducteurs au moyen de commandes de lecture, à l'interface de sortie ;

la mémoire à semi-conducteurs étant une mémoire dynamique synchrone à accès aléatoire, chacune des commandes d'écriture étant une commande d'écriture SDRAM pour au moins une partie d'une rangée SDRAM, et chaque commande d'écriture SDRAM est calculée si bien que les données désentrelacées sont écrites et lues en mode rafale SDRAM ;

dans lequel le dispositif de mappage comprend deux mémoires SRAM, et le dispositif de mappage est agencé pour générer de manière itérative une adresse d'écriture pour l'une des commandes d'écriture et une adresse de lecture pour l'une des commandes de lecture dans les mémoires respectives desdites mémoires SRAM.

**2.** Dispositif selon la revendication 1, dans lequel l'interface de sortie est connectée à un mappeur de correction d'erreurs sans voie de retour (FEC).

**3.** Dispositif selon la revendication 2, dans lequel chaque commande de lecture SDRAM est mise en mémoire tampon à l'aide du mappeur FEC pour la lecture par rafales.

**4.** Dispositif selon l'une quelconque des revendications 1 à 3, dans lequel le désentrelacement est effectué sur la base d'une rangée SDRAM au lieu d'une base de cellules de désentrelacement temporel, TDI.

**5.** Dispositif selon l'une quelconque des revendications 1 à 3, dans lequel le mappeur de rangées est agencé pour effectuer un mappage des cellules TDI vers la rangée SDRAM et mettre en mémoire tampon les commandes d'accès en écriture SDRAM pour l'écriture par rafales SDRAM.

**6.** Récepteur de diffusion vidéo numérique - deuxième génération terrestre DVB-T2, comprenant le dispositif selon l'une quelconque des revendications 1 à 5.

Fig. 1

Fig. 2

Ping buf

| C(0) |
| --- |
| C(1) |
| ... |
| C(Ncells-2) |
| C(Ncells-1) |

Pong buf

| C(0) |
| --- |
| C(1) |
| ... |
| C(Ncells-2) |
| C(Ncells-1) |

Ping_addr

Pong_addr

PingPong switch

TIME de-Interleaver Address generator

sequential counter generator

Fig. 3

Ping buf

| C(0) |
| C(1) |
| ... |
| C(Ncells-2) |
| C(Ncells-1) |

read
address

TIME de-
Interleaver
Address generator

Write
address

Fig. 4

Fig. 5

Fig. 6

Fig. 7

Fig. 8

18

Fig. 9

Fig. 10

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2014068168 A1

- EP 2525538 A2

**Non-patent literature cited in the description**

- Implementation guidelines for a second generation digital terrestrial television broadcasting system (DVB-T2). *Draft ETSI TR 102 831 3 V0.10.00,* November 2009